# EUROPÄISCHE PATENTSCHRIFT

(11) **EP 2 671 434 B1**
(45) Veröffentlichungstag und Bekanntmachung des Hinweises auf die Patenterteilung: **17.05.2017**
(21) Anmeldenummer: 12708652.8
(22) Anmeldetag: 16.01.2012
(51) Int. Cl.: H05K 7/14, H05K 7/20

(54) **ELEKTRISCHES GERÄT**
ELECTRICAL DEVICE
APPAREIL ÉLECTRIQUE

(30) Priorität: 04.02.2011 DE 102011010432
(43) Veröffentlichungstag der Anmeldung: 11.12.2013
(73) Patentinhaber: Sew-Eurodrive GmbH & Co. KG, 76646 Bruchsal (DE)
(72) Erfinder: SCHÖRNER, Martin, 76646 Bruchsal (DE)
(86) Internationale Anmeldenummer: PCT/EP2012/000159
(87) Internationale Veröffentlichungsnummer: WO 2012/104017

(56) Entgegenhaltungen:
- DE-A1- 10 234 477
- DE-A1-102006 022 497
- US-A- 3 735 206
- US-A- 5 060 115

## Beschreibung

Die Erfindung betrifft ein elektrisches Gerät.

Es ist bekannt, dass Umrichter als Elektrogerät Signalelektronik und Leistungselektronik aufweisen. Dabei wird von der Leistungselektronik ein Verbraucher, wie Elektromotor, gespeist. Die Wärme, insbesondere die Wärme der Leistungshalbleiterschalter der Leistungselektronik, wird an einen Kühlkörper abgeführt und von dort an die Umgebungsluft oder ein anderes umgebendes Kühlmedium.

Zur Verbesserung von Wärmeübergängen ist es bekannt, Wärmeleitpaste in den Wärmeübergangsbereich einzubringen.

**Aus der De** 10 2006 022 497 A1 **ist eine zylinderförmige Baugruppe mit einem elektronischen Bauteil bekannt.**

**Aus der** US 5 060 115 A **ist eine Kühlvorrichtung für ein Elektronikmodul in zylindrischem Gehäuse bekannt.**

**Aus der** US 3 735 206 A **ist eine Vorrichtung mit keilförmiger Schaumstoffverpackung bekannt.**

**Aus der** DE 102 34 477 A1 **ist eine Leistungshalbleitereinrichtung bekannt.**

Der Erfindung liegt daher die Aufgabe zugrunde, ein elektrisches Gerät weiterzubilden, wobei die Fertigung einfach sein soll.

Erfindungsgemäß wird die Aufgabe bei dem Gerät nach den in Anspruch 1 angegebenen Merkmalen gelöst.

Wichtige Merkmale bei dem Gerät sind, dass es eine Leiterplatte aufweist, die mit wärmeerzeugenden Bauteilen bestückt ist,
wobei die Leiterplatte in einem Gehäuse des Geräts angeordnet ist,
wobei das Gehäuse ein Gehäuseteil aufweise, insbesondere ein topfförmiges Gehäuseteil,
wobei eine mit der Leiterplatte verbundene Kühlplatte von einem Keil gegen die Innenwandung des Gehäuseteils angedrückt ist,
insbesondere derart angedrückt ist, dass an einer Kontaktfläche Wärme zumindest eines wärmeerzeugenden Bauteils, insbesondere eines Leistungshalbleiterschalter aufweisenden Leistungsmoduls, an das Gehäuseteil abführbar ist.

Von Vorteil ist dabei, dass eine einfache aber leistungsfähige Verbindungstechnik zwischen Kühlplatte und Gehäuseteil verwendet ist. Somit ist ein guter Wärmeübergang bewirkbar und sogar Wärmeleitpaste verzichtbar. Fertigungstoleranzen sind einfach und leicht ausgleichbar. Ein Verspannen ist ohne Versatz durchführbar, da dieser durch Fertigungstoleranzen nicht bewirkbar wäre. Keil und zugehörige Schraube sind in der aus Leiterplatte und Kühlplatte gebildeten Kassette vormontierbar vor dem Verbinden der Kassette mit dem Topfförmigen Gehäuseteil.

Weiter ist der Umweltschutz verbessert, weil bei defekter Elektronik nur die Kassette auszutauschen ist. Das topfförmige Gehäuseteil ist wiederverwendbar und kann beim Austausch der Kassette in der Anlage installiert bleiben. Dies verringert auch den Reparaturaufwand.Erfindungsgemäß ist der Keil abgestützt an einem Abschnitt des Gehäuseteils, insbesondere an einem in den vom Gehäuseteil umgebenen Innenraumbereich des Geräts hineinragenden Abschnitt des Gehäuseteils. Von Vorteil ist dabei, dass ein Verspannen der Kühlplatte durch den Keil mittels Abstützen am Abschnitt und Andrücken der Kühlplatte an das Gehäuseteil erreichbar ist.

Bei einer vorteilhaften Ausgestaltung ist der Abschnitt ein Befestigungsdom. Von Vorteil ist dabei, dass eine einstückige Fertigung des Gehäuseteils zusammen mit dem Abschnitt einfach ausführbar ist. Alternativ ist auch eine zweistückige Ausführung ausführbar, wenn eine entsprechende Verbindung der Stücke gemacht wird.

Bei einer vorteilhaften Ausgestaltung ist eine Schraube in eine Ausnehmung, insbesondere Gewindebohrung, des Abschnitts derart einschraubbar, dass beim Einschrauben die Schraube, insbesondere deren Schraubenkopf, auf den Keil drückt und somit über eine Schrägfläche, insbesondere eine zur Schraubachsrichtung einen Winkel zwischen 0° und 90° aufweisenden Fläche, vom Keil eine Andruckkraft auf die Kühlplatte geleitet wird. Von Vorteil ist dabei, dass Fertigungstoleranzen einfach ausgleichbar sind und mit einer großen Kraft die Kühlplatte an die Innenwandung des Gehäuseteils anpressbar ist.Gemäß der Erfindung weist der Abschnitt eine Führung für den Keil auf, insbesondere wobei die Führung zumindest eine Führungsnut aufweist, welche parallel zur Schraubenachsrichtung ausgerichtet ist. Von Vorteil ist dabei, dass der Keil in der Schraubenachsrichtung führbar ist und die Andrückkraft über eine schrägfläche einfach ableitbar ist.

Bei einer vorteilhaften Ausgestaltung weist der Keil eine Ausnehmung auf, insbesondere ein Rundloch oder eine Rundbohrung, durch welches beziehungsweise durch welche die Schraube hindurchragt. Von Vorteil ist dabei, dass der Durchmesser der Ausnehmung kleiner ist als der Außendurchmesser des Schraubenkopfes aber größer als der Durchmesser des Schraubgewindes. Somit ist der Schraubenkopf als Anpressmittel verwendbar.

Bei einer vorteilhaften Ausgestaltung sind zwei derartige Keile an der Leiterplatte vorgesehen und somit eine stabile Verbindung zwischen Kassette und Gehäuseteil erreichbar.

Bei einer vorteilhaften Ausgestaltung umschließt ein Kunststoffkörper die Leiterplatte zumindest teilweise und ist mit der bestückten Leiterplatte verbunden, insbesondere stoffschlüssig und/oder formschlüssig. Von Vorteil ist dabei, dass die Leiterplatte samt der bestückten Bauelemente geschützt ist vor mechanischen Einwirkungen, wie Kraftstößen, Erschütterungen oder dergleichen. Insbesondere sind auch herausstehende Bauteile gegen Schwingungen besser stabilisierbar mittels des Kunststoffkörpers. Somit ist eine sichere Transportfähigkeit und Lagerfähigkeit gewährleistbar, wobei die Leiterplatte nicht eingebaut ist im Gehäuse des Geräts. Bei wärmeleitender Ausführung des Kunststoffkörpers ist auch eine verbesserte Entwärmung der Wärme erzeugenden Bauelemente erreichbar.

Alternativ ist beidseitig der Leiterplatte ein Kunststoffkörper angeordnet und mit der bestückten Leiterplatte verbunden, insbesondere stoffschlüssig und/oder formschlüssig. Von Vorteil ist dabei, dass der Kunststoffkörper die Leiterplatte umgibt und somit ein guter mechanischer Schutz gewährleistbar.

Bei einer vorteilhaften Ausgestaltung ist der Kunststoffkörper aus mindestens zwei miteinander formschlüssig verbundenen Teilkörpern zusammengesetzt, insbesondere wobei die formschlüssige Verbindung eine Verrastung ist. Von Vorteil ist dabei, dass die Teilkörper vorfertigbar sind und somit um die Leiterplatte anordenbar und miteinander verbindbar sind. Somit muss die Leiterplatte nicht belastet werden beim Anordnen der Teilkörper um die Leiterplatte herum.

Bei einer vorteilhaften Ausgestaltung ist der Kunststoffkörper einstückig ausgebildet, insbesondere als Umspritzung oder als Kunststoffgussteil hergestellt. Von Vorteil ist dabei, dass eine besonders kostengünstige Herstellung ausführbar ist, da die Leiterplatte nur in eine Werkzeugform eingebracht werden muss und dann umspritzbar oder umgießbar ist.

Bei einer vorteilhaften Ausgestaltung weist die bestückte Leiterplatte an ihrer Oberfläche einen Lack auf, insbesondere einen wasserdampfabweisenden Lack und/oder einen wasserabweisenden Lack. Von Vorteil ist dabei, dass die Leiterplatte in einer Werkzeugform mit Styroporkügelchen umgebbar und Wasserdampf hinzugebbar ist, so dass in einfacher Herstellungsweise eine Ummantelung mit Styropor produzierbar. Unter Styropor wird dabei auch jeder andere geschäumte Kunststoff verstanden, insbesondere welcher wärmeleitend und elektrisch isolierend ist und vorzugsweise einen Flammschutz-Zusatz aufweist.

Bei einer vorteilhaften Ausgestaltung ist der Kunststoff als Styropor oder als Schaumstoff, insbesondere als ein Polyurethanschaum, ausgeführt. Von Vorteil ist dabei, dass ein kostengünstiges Material verwendbar ist, das durch chemische Zusatzbestandteile mit verbesserter Wärmeleitfähigkeit ausstattbar ist.

Bei einer vorteilhaften Ausgestaltung weist der Kunststoff eine bessere Wärmeleitfähigkeit, insbesondere spezifische Wärmeleitfähigkeit, auf als Luft,

insbesondere wobei der Kunststoffkörper aus elektrisch isolierendem Werkstoff gefertigt ist. Von Vorteil ist dabei, dass durch entsprechende Zusätze die Wärmeleitfähigkeit verbesserbar ist. Außerdem ist somit Luft als Wärmetransportmittel verzichtbar und ein direktes Zwischenordnen des Kunststoffkörpers zwischen Leiterplatte und Kühlplatte ermöglicht.

Bei einer vorteilhaften Ausgestaltung ist das Elektrogerät ein Umrichter ist, insbesondere wobei die Signalelektronik und die Leistungselektronik des Umrichters auf der Leiterplatte angeordnet. Von Vorteil ist dabei, dass nur eine Leiterplatte zu bestücken ist und somit eine hochautomatisierte Herstellung ermöglicht ist, da das Bestücken durch Bestückungsautomaten ausführbar ist. Außerdem ist das Verbinden der elektronischen Schaltung, also umfassend die Leiterplatte mit verbundener Kühlplatte, mit dem Gehäuse besonders einfache und leicht ausführbar, da nur ein Einschieben der elektronischen Schaltung ins topfförmige Gehäuse auszuführen ist.

Bei einer vorteilhaften Ausgestaltung ist auf der Leiterplatte ein Leistungsmodul angeordnet, welches mit einer Kühlplatte, insbesondere auf eine Aluminium enthaltendes Kühlplatte, verbunden ist,
insbesondere auf diese Kühlplatte aufgeschraubt ist und mit dieser wärmeleitend verbunden ist zur Abfuhr von Wärme. Von Vorteil ist dabei, dass bei Montage die Kühlplatte über das Leistungsmodul mit der Leiterplatte verbindbar ist. Somit ist mit dem Kunststoffkörper eine erste Seite der Leiterplatte schützbar, also die von der Kühlplatte abgewandte Seite der Leiterplatte, und es ist die andere Seite der Leiterplatte nicht nur durch den restlichen Teilkörper des Kunststoffkörpers schützbar sondern auch durch die Kühlplatte.

Bei einer vorteilhaften Ausgestaltung ist die Kühlplatte außerhalb des Kunststoffkörpers angeordnet, insbesondere wobei das Leistungsmodul durch eine Ausnehmung des Kunststoffkörpers hindurchragt. Von Vorteil ist dabei, dass die Wärmeableitung durch den ansonsten schützenden Kunststoffkörper nicht beeinträchtigt wird.

Bei einer vorteilhaften Ausgestaltung weist der Kunststoffkörper Ausnehmungen für auf der Leiterplatte bestückte Bauteile, insbesondere für große Bauteile, auf. Von Vorteil ist dabei, dass in diesen Bereichen die Wärmeabfuhr an die Kühlplatte mittels Luft ausführbar ist oder - wie bei dem Leistungsmodul - durch eine Kontaktfläche an der Kühlplatte.

Bei einer vorteilhaften Ausgestaltung weist der Kunststoffkörper, insbesondere der zweite Teilkörper, eine weitere Ausnehmung auf, die eine Luftverbindung zwischen einem Wärme erzeugenden, auf der Leiterplatte bestückten Bauelement und einem Oberflächenteilbereich der Kühlplatte ist, insbesondere zur konvektiven Ableitung von Wärme mittels der Luftverbindung an die Kühlplatte. Von Vorteil ist dabei, dass mittels der dem jeweiligen Wärme erzeugenden Bauelement beziehungsweise dem zugehörigen Oberflächenberiech der Leiterplatte zugeordneten Ausnehmung im Kunststoffkörper ein Luftraumbereich geschaffen ist, der zumindest teilweise von einem Oberflächenbereich der Kühlplatte begrenzt wird und von einem jeweiligen Wärme erzeugenden Bauelement beziehungsweise von dem hierzu zugehörigen Oberflächenbereich der Leiterplatte. Somit bildet sich bei Temperaturdifferenzen konvektiv angetriebene Luftströmung aus, so dass eine Wärmeabfuhr an die Kühlplatte ermöglicht ist.

Bei einer vorteilhaften Ausgestaltung ist eine erste Seite der Leiterplatte oder zumindest ein Teilbereich dieser Seite, insbesondere lückenlos, bedeckt, also abgedeckt von dem Kunststoffkörper, insbesondere von dessen erstem Teilkörper, und
die andere Seite der Leiterplatte ist zumindest teilweise bedeckt, also abgedeckt, von dem Kunststoffkörper, insbesondere von dessen zweitem Teilkörper, insbesondere wobei der zweite Teilkörper ringförmig ausgebildet ist. Von Vorteil ist dabei, dass die abgedeckten auf der Leiterplatte bestückten Bauelemente geschützt sind vor Umwelteinflüssen, wie beispielsweise mechanischer Krafteinwirkung. Der Kunststoffkörper führt also gehäusebildende Funktionen aus - soweit die Bedeckung sich erstreckt. Dabei ist er allerdings elastischer als ein Aluminiumgehäuse. Erst nach Einbau in das topfförmige Gehäuseteil und Verschließen desselben mit dem Deckelteil ist ein vollständiges Gehäuse geschaffen. In diesem eingebauten Zustand übernimmt der Kunststoffkörper dann auch Wärme ableitende Funktion beziehungswiese schafft Luftraumbereiche zur gezielten Entwärmung von Wärme erzeugenden Bauelementen, wenn seine Wärmeleitfähigkeit geringer als die von Luft ist.

Bei einer vorteilhaften Ausgestaltung weist das Gehäuse des Geräts ein topfförmiges Gehäuseteil auf, das von einem Deckelteil verschlossen ist,
insbesondere wobei an der Innenwandung des topfförmigen Gehäuseteils eine Kontaktfläche zur Wärmeeinleitung von der Kühlplatte ans Gehäuse angeordnet ist. Von Vorteil ist dabei, dass die von der Kühlplatte ans Gehäuse eingeleitete Wärme aufspreizbar ist über das ganze topfförmige Gehäuseteil. Somit verteilt sich die Wärme auf eine große Oberfläche. Dabei ist allerdings die Kontaktfläche zur Kühlplatte in möglichst guten Wärmekontakt zu bringen. Da die Kühlplatte selbst schon flächig und groß, insbesondere vergleichbar mit der ganzen Leiterplatte, ausführbar ist, ist ein hinreichender Wärmeübergang einfach herstellbar, insbesondere sogar ohne Wärmeleitpaste im Kontaktbereich. Der Einbau der Kassette, bestehend aus Kühlplatte, Kunststoffkörper und Leiterplatte, in das topfförmige Gehäuse ermöglicht auch das Herstellen von verschiedenen Varianten in einfacher Weise. Denn stets dieselbe Kassette ist in verschiedene Gehäuseteile einbaubar. Somit sind applikationsspezifische oder marktspezifische Besonderheiten durch entsprechend Modifizierte Gehäuseteile abdeckbar. Die Deckelteil sind entsprechend variierbar. Eine hohe Varianz ist mit einer geringen Anzahl von Bauteilen erzeugbar.

Bei einer vorteilhaften Ausgestaltung sind zwischen Deckelteil und Gehäuseteil Kabeldurchführungen angeordnet, insbesondere für Versorgungsleitungen, einen Verbraucher speisenden Leitungen und Datenbusleitungen. Von Vorteil ist dabei, dass das topfförmige Gehäuse mit möglichst tief liegendem Boden ausführbar ist, also mit hohen Topfseitenwänden.

Wichtige Merkmale bei dem Verfahren zum Herstellen eines elektrischen Geräts sind, dass das Gerät eine zumindest mit einem Leistungsmodul und weiteren Bauteilen bestückte Leiterplatte aufweist, insbesondere wobei die Bauteile und das Leistungsmodul somit auf der Leiterplatte befestigt sind,
wobei
(i) in einem Verfahrensschritt die Leiterplatte zumindest teilweise mit einem Kunststoffkörper umschlossen wird, insbesondere
   - mit Kunststoff zumindest teilweise umspritzt wird zur Bildung des Kunststoffkörpers
   - oder zwischen mindestens zwei Teilkörper des zumindest zweistückig ausgebildeten Kunststoffkörpers eingelegt wird, wobei die Teilkörper nach dem Einlegen miteinander verbunden werden, insbesondere formschlüssig und/oder mittels Verrastung,
(ii) in einem nachfolgenden Verfahrensschritt eine Kühlplatte mit dem Leistungsmodul verbunden, insbesondere schraubverbunden, wird,
(iii) in einem weiter nachfolgenden Verfahrensschritt die Leiterplatte samt Kühlplatte und Kunststoffkörper in ein topfförmiges Gehäuseteil eingeschoben wird und die Kühlplatte an einer Kontaktfläche der Innenwandung des Gehäuseteils angedrückt wird, insbesondere wärmeleitend verbunden wird.

Von Vorteil ist dabei, dass die Leiterplatte von einem schützenden Kunststoffkörper umgeben wird und somit beim Transport und Lagern geschützt ist. Nach Verbinden der Kühlplatte ist der Schutz erhöht und die elektronische Schaltung als Einheit, insbesondere Kassette, transportierbar. Zur Endmontage muss nur die Kassette in das topfförmige Gehäuse eingeschoben werden und mit ihrer Kühlplatte in Kontakt gebracht werden zur Wärmeableitung ans topfförmige Gehäuse. Das Gehäuse ist dabei aus Metall, wie beispielsweise Aluminium, damit die Wärme gut abgeleitet wird und eine hohe mechanische Stabilität gehäusebildend eingesetzt wird.

Weitere Vorteile ergeben sich aus den Unteransprüchen.

Die Erfindung wird nun anhand von schematischen Abbildungen näher erläutert:
In der Figur 1 ist ein erfindungsgemäßer Umrichter mit einem aus einem ersten und einem zweiten Schaumteil gebildeten Kunststoffkörper rein schematisch skizziert.
In der Figur 2 ist die Kontur der Ausnehmung im zweiten Schaumteil 4 ebenfalls rein schematisch gezeigt.
In der Figur 3 ist eine Schrägansicht auf den angeschnittenen Umrichter in konkreter Darstellung gezeigt bei entferntem Deckelteil 8.
In der Figur 4 ist eine Schrägansicht auf die aus Leiterplatte 12 und Kühlplatte 1 gebildete Kassette gezeigt, die im Innenraum des Umrichters angeordnet ist.
In der Figur 5 ist ein vergrößerter Ausschnitt der Figur 4 gezeigt.
In der Figur 6 ist eine Schrägansicht auf den Umrichter bei entferntem Deckelteil 8 gezeigt.
In der Figur 7 ist ein Querschnitt durch den Umrichter bei entferntem Deckelteil 8 gezeigt.
In der Figur 8 ist ein Querschnitt durch die Kassette gezeigt.
In der Figur 9 ist ein anderer Querschnitt durch die Kassette gezeigt.
In der Figur 10 ist eine Seitenansicht der Kassette gezeigt.

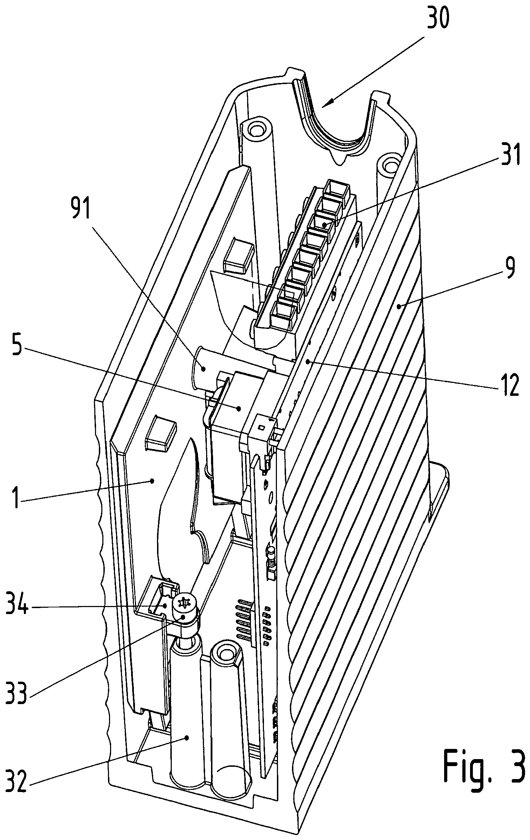

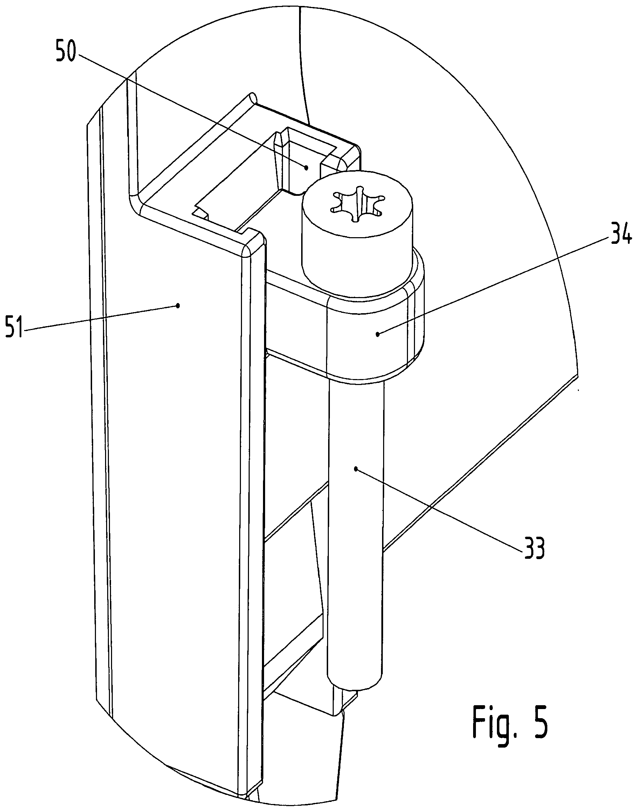

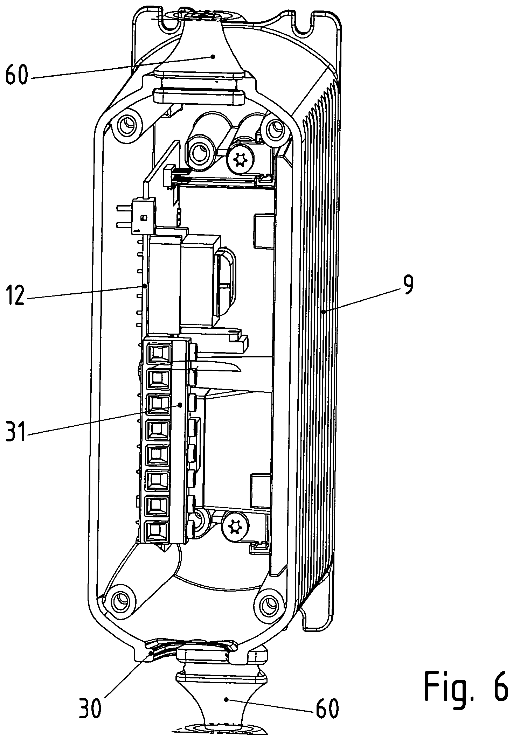

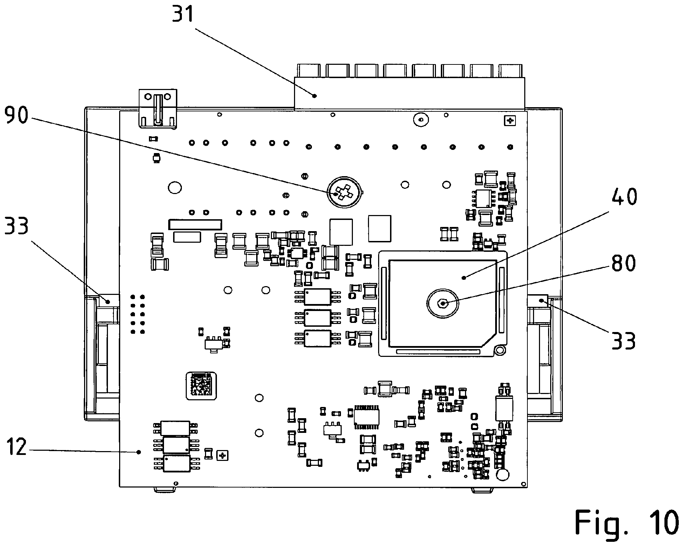

In den Figuren 3 bis 10 ist der Kunststoffkörper jeweils entfernt.

Das Gehäuse des Umrichters weist ein topfförmiges einstückig vorzugsweise aus Aluminium gefertigtes Gehäuseteil 9 auf, das mittels eines Deckelteils 8 verschlossen ist. Im Zwischenbereich zwischen Deckelteil 8 und topfförmigem Gehäuseteil 9 sind Kabeldurchführungen vorgesehen, so dass einerseits Versorgungskabel in den Innenraum einführbar sind und andererseits Verbindungskabel zum vom Umrichter gespeisten Elektromotor, also Verbraucher, herausführbar sind. Außerdem sind auch Datenbuskabel durch eine dortige Kabeldurchführung hindurch in den Innenraum geführt.

Der Elektromotor ist vorzugsweise ein Drehstrommotor. Die Versorgungskabel führen vorzugswiese einphasig oder dreiphasig Netzwechselspannung.

Im Innenraum des Umrichters ist eine Kassette eingeschoben, die die Leiterplatte 12 des Umrichters umfasst und eine Kühlplatte 1.

Auf der Leiterplatte ist die gesamte elektronische Schaltung des Umrichters angeordnet, also Signalelektronik und Leistungselektronik. Dabei gehören zur Leistungselektronik zumindest
- ein Gleichrichter, welcher die mittels der Versorgungskabel zugeführte Wechselspannung gleichrichtet,
- ein Zwischenkreiskondensator zum Glätten der gleichgerichteten Spannung und
- ein Leistungsmodul, welches in Halbbrücken angeordnete Leistungshalbleiterschalter aufweist, von welchen die den Motor speisenden Leitungen gespeist werden.
Die Signalelektronik erzeugt pulsweitenmodulierte Ansteuersignale für die Leistungshalbleiterschalter und ist mit dem Datenbus verbunden.

Die Leiterplatte 12 ist also mit zumindest einem großen Bauteil 3 bestückt wie beispielsweise der Zwischenkreiskondensator und Leistungsmodul 5. Außerdem ist die Leiterplatte 12 auch mit kleinen Bauteilen 11 bestückt, wie SMD-Bauteile.

Das Leistungsmodul 5 ist mittels einer Verbindungsschraube, aufweisend einen Schraubenkopf 7, an eine Kühlplatte 1 angeschraubt, so dass die Wärme des Leistungsmoduls an der Kontaktfläche zur Kühlplatte 1 abführbar ist. Das Leistungsmodul 5 weist als Kontaktfläche eine keramisierte oder mit Kupfer überzogene Kontaktfläche auf. Die Kühlplatte 12 ist vorzugswiese aus Aluminium ausgeführt. Somit ist ein gut wärmeleitender Kontakt herstellbar und die Wärme effektiv abführbar.

Die Kühlplatte weist eine Plattenfläche von mehr als 50%, insbesondere von mehr als 80% oder 90% der Leiterplattenfläche auf. Es ist sogar eine verbesserte Wärmeaufspreizung erreichbar, wenn die Plattenfläche der Kühlplatte 1 die Leiterplattenfläche übersteigt.

Somit ist eine Aufspreizung der vom Leistungsmodul erzeugten Wärme erreicht.

Bei Einführen der Kassette ins topfförmige Gehäuseteil 9 wird die Kühlplatte an die Innenwandung des topfförmigen Gehäuseteils angedrückt, insbesondere zunehmend angedrückt beim Anziehen von entsprechenden Verbindungsschrauben, welche die Verbindung der Kassette mit dem topfförmigen Gehäuseteil 9 bewirken. Somit wird die Wärme von der Kühlplatte 1 dann an das topfförmige Gehäuseteil 9 übertragen und somit aufgespreizt.

Wichtig ist dabei, dass das topfförmige Gehäuseteil die Kassette mit Ausnahme des Deckelteilbereichs umschließt. Somit sitzt die Leiterplatte beidseitig in diesem thermisch ungefähr gleiche Temperatur aufweisenden Gehäuseteil 9. Die Signalelektronik und Leistungselektronik sind also auf gleichem Temperaturniveau.

Die Leiterplatte 12 ist beidseitig von Schaumteilen umgeben, also sozusagen eingepackt. Nur Auf einer Seite ist eine Kühlplatte 1 angeordnet, so dass nur die Leiterplatte 12 nicht aber die Kühlplatte 1 beidseitig eingepackt ist.

Auf der ersten Seite der Leiterplatte ist ein das erste Schaumteil 10 angeordnet. Auf der anderen Seite, also zwischen Kühlplatte 1 und Leiterplatte 12 ist das zweite Schaumteil 4 angeordnet.

Die beiden Schaumteile 4 und 10 sind mittels einer Verrastung verbindbar. Somit umklammern sie sozusagen die Leiterplatte 12.

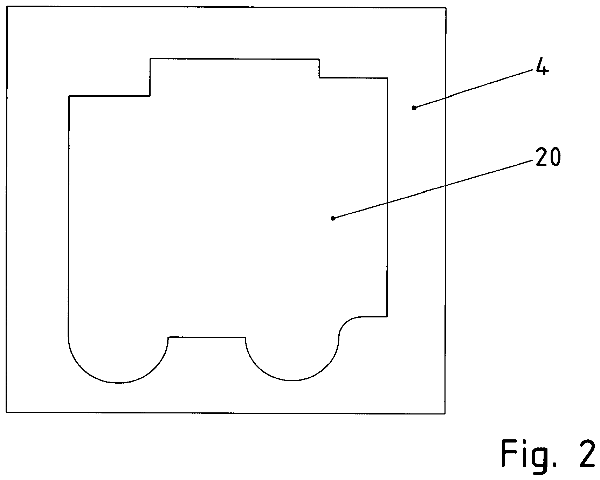

Das zweite Schaumteil 4 weist Ausnehmungen auf, für die großen Bauteile 3 und das Leistungsmodul 5. Da verbleibende Stege aus Stabilitätsgründen eine Mindestwandstärke aufweisen müssen, ergibt sich bei eng angeordneten großen Bauteilen 3 und Leistungsmodul 5 anstatt einzelner voneinander beabstandeter Ausnehmungen im Schaumteil 4 eine einzige große Ausnehmung 20 wie in Figur 2 gezeigt. Somit leitet die in den Zwischenräumen zwischen den großen Bauteilen und innerhalb des zweiten Schaumteils 4 angeordnete Luft Konvektiv Wärme von heißen zu kalten Oberflächenbereichen, insbesondere also zur Kühlplatte 1 hin.

Das zweite Schaumteil 4 ist gemäß Figur 2 als ringförmige Struktur ausgeprägt.

Die Verrastung 2 beziehungsweise 6 der Schaumteile 4 und 10 wird durch deren Ausformung erreicht, ist also ohne zusätzliche Teile ausführbar. Hierbei wird an einem der Schaumteile 4 oder 10 eine Rastnase ausgeformt und am anderen eine entsprechende Ausnehmung mit Rast-Vorsprung. Durch Hintergreifen des Vorsprungs, also Verrastung, ist eine formschlüssige Verbindung herstellbar.

Die Schaumteile 4 und 10 bilden einen Schutz für die Leiterplatte gegen mechanische Einwirkungen, wie Kraftstöße und/oder Schwingungen. Somit ist die Leiterplatte 12 in dieser durch die Schaumteile 4 und 10 gebildeten Verpackung sicher lagerbar und transportierbar.

Außerdem sind je nach Applikation oder Kundenwunsch verschieden geformte topfförmige Gehäuseteile 9 mit der Kassette verbindbar. Ebenso sind verschieden ausgeprägte Deckelteile 8 verbindbar. Auf diese Weise lassen sich also Umrichter mit verschiedenem äußeren Erscheinungsbild und entsprechend verschiedenen Funktionalitäten herstellen, ohne dass die Leiterplatte jedesmal anders ausgeführt werden muss. Wichtig ist dabei nur, dass die Schnittstelle zur Kassette hin kompatibel ist, insbesondere muss die Schnittstelle zur Anbindung der kühlplatte 1 zur Innenwandung des topfförmigen Gehäuseteils 9 eingehalten werden.

Die Verrastung 2 und 6 ist vorzugsweise lösbar ausgeführt.

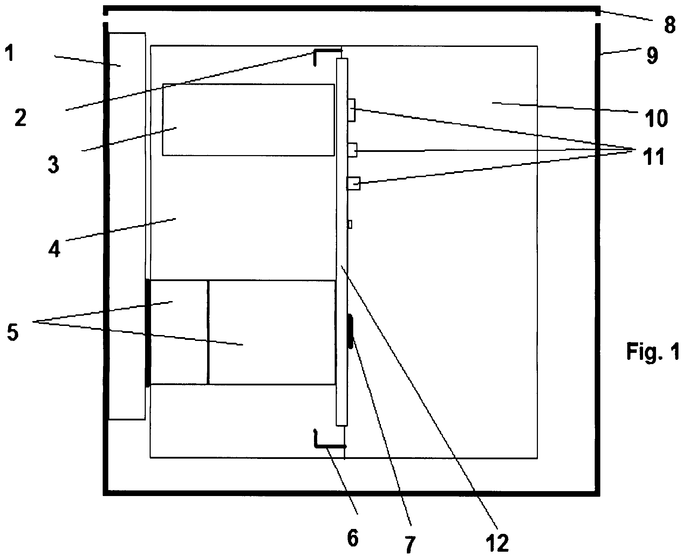

In einem weiteren erfindungsgemäßen Ausführungsbeispiel ist die Beabstandung der großen Bauteile 3 voneinander und vom Leistungsmodul 5 größer als in Figur 1 und 2. Somit weist dann das zweite schaumteil mehrere Ausnehmungen auf, die jeweils deutlich kleiner sind als die in Figur 2 gezeigte Ausnehmung. Dabei werden aber Ausnehmungen derart dimensioniert und angeordnet, dass heiße Wärmequellen durch die in den jeweiligen Ausnehmungen sich ausbildenden konvektiven Luftströmungen zur Kühlplatte 1 hin entwärmt werden. Diese Ausbildung der Ausnehmungen als konvektiv betriebene Luftbereiche ist dann besonders vorteilhaft, wenn die Wärmeleitfähigkeit des Schaumteilwerkstoffs niedriger ist als die von Luft.

Unter Luft ist bei der vorliegenden Erfindung die Umgebungsluft des Umrichters und/oder Luft mit einer Temperatur von 20 ° C bei 1 bar Druck und einer Feuchtigkeit von 30% zu verstehen,

Wenn die Wärmeleitfähigkeit des Schaumteilwerkstoffes diejenige von Luft übersteigt, wird auf die Ausnehmungen für konvektiv betriebene Luftbereiche möglichst verzichtet. Es werden also dann nur Ausnehmungen für die großen Bauteile 3 und das Leistungsmodul 5 vorgesehen.

Als Schaumstoffwerkstoff ist ein Polyurethan verwendbar oder auch Styropor.

In einem weiteren erfindungsgemäßen Ausführungsbeispiel wird die bestückte Leiterplatte 12 nicht mit zwei Schaumteilen mechanisch verbunden sondern es wird ein Schaumteil umspritzend hergestellt oder bei der Styroporherstellung. Hierbei wird die bestückte Leiterplatte mit einem wasserundurchlässigem oder wasserdampfundurchlässigem Lack lackiert, beispielsweise als Tauschlack. In einem weiteren Herstellschritt wird dann die so lackierte Leiterplatte 12 in eine Werkzeugform eingelegt und dann der verbleibende Innenbereich der Form mit Styroporkügelchen befüllt. Durch zusätzliches Einführen von heißem Wasserdampf werden die Styroporkügelchen miteinander formschlüssig verbunden, so dass die Schaumteile 4 und 10 einstückig ausgeformt sind und keine zusätzlichen Ausnehmungen für Luft oder dergleichen enthalten. Dabei ist die Wärmeleitung des entstehenden Styropors durch chemische Zusätze derart verbessert, dass sie besser ist als die von Luft. Statt des Styropors ist auch ein anderer zum Umspritzen geeigneter elektrisch isolierender aber besser als Luft wärmeleitender Werkstoff verwendbar. Je nach Herstellverfahren ist dann die Lackierung mit wasserdampf- oder wasserabweisendem Lack verzichtbar.

Vorzugsweise wird auf Wärmeleitpaste im Kontaktbereich zwischen Kühlplatte und Gehäuseteil verzichtet. Die Fläche ist hierfür genügend groß, so dass die Wärme entsprechend effektiv aufgespreizt ist.

Wie in Figur 3 gezeigt ist am oberen Randbereich, also an dem dem Deckelteil 8 zugewandten Randberiech eine Aufnahme 30 für Kabeldurchführung 60 angeordnet. Dabei verläuft die die Aufnahme 30 bildende Ausnehmung U-förmig. Nach unten, also in Richtung zum Boden des topfförmigen Gehäuseteils 9 hin, ist die Ausnehmung also verjüngt ausgeführt. Die lichte Weite nimmt also in dieser Richtung monoton ab. Somit ist eine elastische Kabeldurchführung 60 einsetzbar, die bei aufsetzen des Deckelteils 8 nach unten gedrückt und dabei elastisch verformt wird. Ein durch die Kabeldurchführung 60 durchgeführtes Kabel wird dabei sehr effektiv abgedichtet.

Auf der Leiterplatte 12 ist auch ein Anschlussmittel 31 für elektrische Leitungen angeordnet, an das die durch eine Kabeldurchführung 60 geführten Versorgungsleitungen und die den Motor speisenden Leitungen elektrisch anschließbar und verbindbar sind.

Die im Deckelteil 8 angeordneten Eingabemittel und Anzeigemittel sind mittels eines vom Deckelteil 8 zur Leiterplatte 12 geführten Kabels elektrisch verbunden, wobei am Ende des Kabels ein Steckverbinderteil angeordnet ist, welches in ein auf der Leiterplatte 12 angeordnetes Gegensteckverbinderteil steckverbindbar ist. Alternativ ist das Steckverbinderteil auch am Deckelteil 8 anordenbar und in das Gegensteckverbinderteil steckverbindbar.

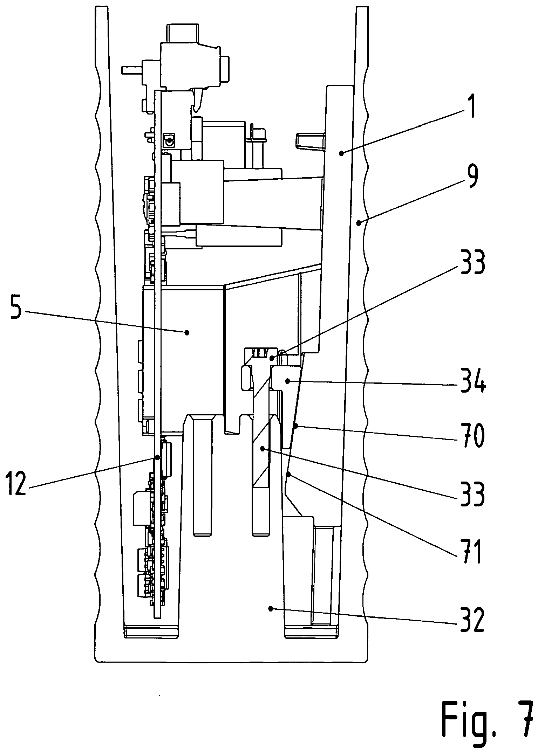

In Figur 3 und Figur 7 ist auch ein am Boden des topfförmigen Gehäuseteils 9 ausgeformter Dom 32 gezeigt, in welchen die Schraube 33 einschraubbar ist. Beim Einschrauben der Schraube 33 wird ein Keil 34 vom Schraubenkopf der Schraube 33 nach unten gedrückt. Dabei ist der Keil 34 seitlich geführt in der seitlichen Führungsnasen 51, welche jeweils eine in Schraubachsenrichtung verlaufende Führungsnut 50 zur Führung des Keils 34 aufweisen.

Der Keil 34 weist ein Loch auf, durch das die Schraube 33 ragt und an dessen Berandungsbereich der Schraubenkopf sich abstützt.

Die Führungsnasen 51 sind an der Kühlplatte 1 ausgeformt. Außerdem ist an der Kühlplatte 1 eine zweite Gleitfläche 71 ausgeformt, welche schräg zur Schraubrichtung und schräg zur Normalenrichtung der Kühlplatte 1 verläuft, also mit sich in Schraubrichtung verringerndem Abstand zur Schraube. Eine entsprechend schräge erste Gleitfläche 70 ist am Keil 34 angeordnet, so dass bei Einschrauben der Schraube 33 in den Dom 32 die Kühlplatte 1 weggedrückt wird vom Dom 32. Auf diese Weise wird die Kühlplatte 1 mit ihrer kontaktfläche an eine entsprechende Kontaktfläche an der Innenwandung des topfförmigen Gehäuseteils 9 gedrückt, die sich auf der von der Schraube abgewandten Seite der Kühlplatte 1 befindet.

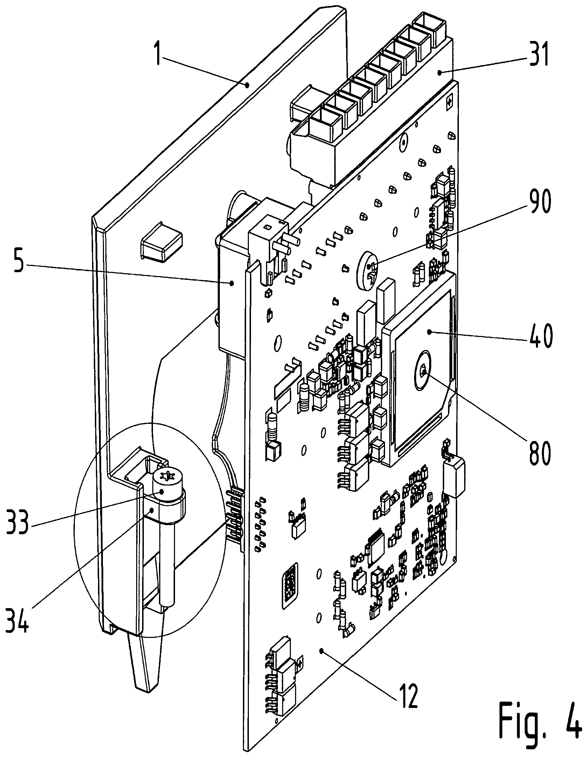

Wie in Figur 4 gezeigt ist, weist das Leistungsmodul 5 eine Kontaktfläche 40 zur Wärmeabfuhr an die Kühlplatte 1 auf. Dabei ist die Kontaktfläche gut wärmeleitend und daher vorzugswiese als Kupfer- oder Keramik-Kontaktfläche ausgebildet.

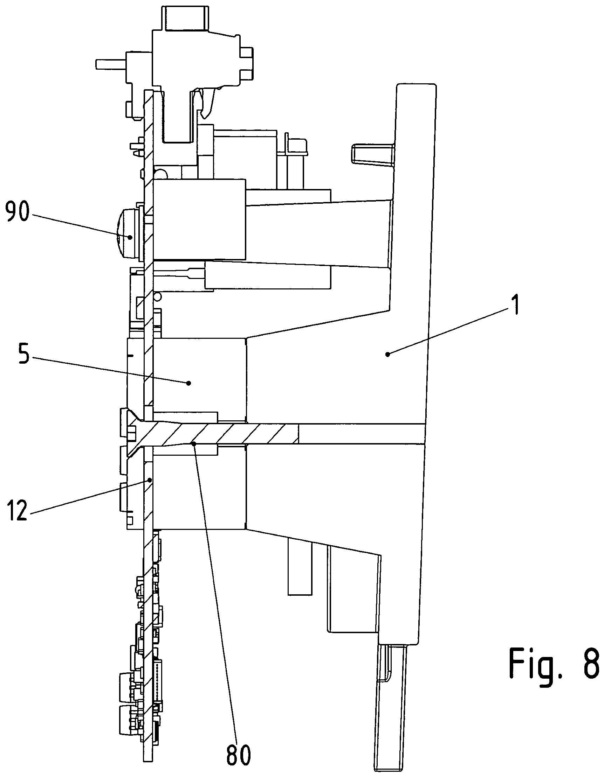

Wie in Figur 8 gezeigt, ist die Leiterplatte mit einer Verbindungsschraube 80 mit der Kühlplatte 1 verbunden, wobei die Verbindungsschraube 80 mittig durch das Leistungsmodul 5 geführt ist und dieses mit seiner Kontaktfläche 40 an die Kühlplatte andrückt. Dabei drückt der Schraubenkopf der Verbindungsschraube über ein plattenförmiges Zwischenteil auf die von der Kühlplatte 1 abgewandte Seite der Leiterplatte 12 und hält somit Leiterplatte 12 und Kühlplatte zusammen. Der Abstand zwischen Leiterplatte 12 und Kühlplatte wird durch das Leistungsmodul vorgegeben, das somit auch als Beabstandungsmittel wirkt.

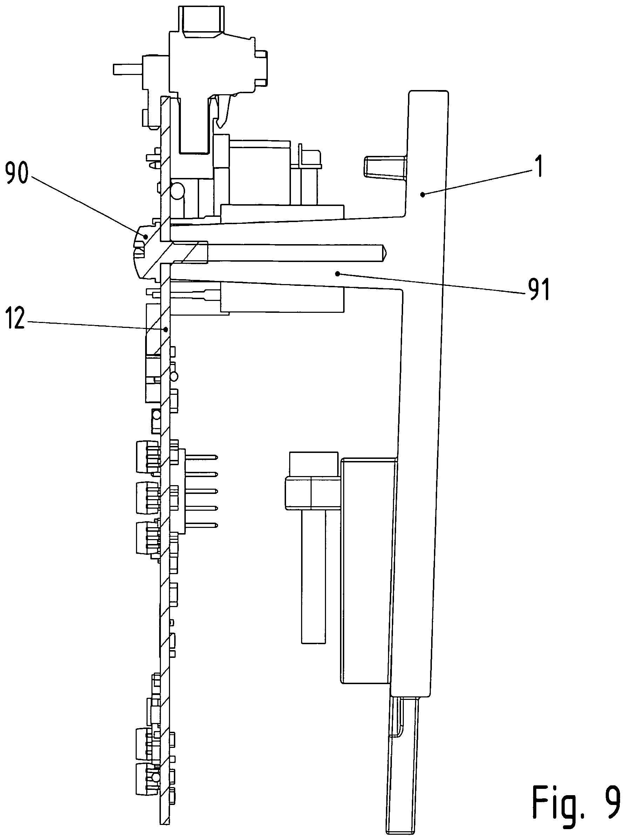

Wie in Figur 9 gezeigt ist, ist eine weitere Verbindungsschraube 90 ebenso an der Leiterplatte angeordnet, deren Schraubenkopf direkt auf die von der Kühlplatte 1 abgewandte Seite der Leiterplatte drückt. Die Verbindungsschraube 90 wird in einen an der Kühlplatte ausgeprägten Befestigungsdom 91 eingeschraubt. Auf diese Weise wird die Leiterplatte 12 auf die Kühlplatte 1 angeschraubt.

Bei einem weiteren erfindungsgemäßen Ausführungsbeispiel sind die Führungsnasen 51 als separates Teil ausgeführt und mit der Kühlplatte 1 entsprechend verbunden.

Bei einem weiteren erfindungsgemäßen Ausführungsbeispiel ist der Befestigungsdom 91 ebenso als separates Teil ausgeführt und mit der Kühlplatte 1 entsprechend verbunden.

### Bezugszeichenliste

- 1: Kühlplatte
- 2: Verrastung
- 3: großes Bauteil, insbesondere Kondensator
- 4: zweites Schaumteil
- 5: Leistungsmodul, aufweisen Leistungshalbleiterschalter
- 6: Verrastung
- 7: Schraubenkopf einer Verbindungsschraube zum Anschrauben des Leistungsmodules (5) an die Kühlplatte 1
- 8: Deckelteil
- 9: topfförmiges Gehäuseteil
- 10: erstes Schaumteil
- 11: SMD-Bauteile oder kleine elektronische Bauteile
- 12: Leiterplatte
- 30: Aufnahme für Kabeldurchführung
- 31: Steckverbinderteil
- 32: Dom, einstückig am Boden des topfförmigen Gehäuseteil 9 ausgebildet
- 33: Schraube
- 34: Keil
- 40: Kontaktfläche zur Wärmeabfuhr, insbesondere Kupfer- oder Keramik-Kontaktfläche
- 50: Führungsnut zur Führung des Keils 34
- 51: seitliche Führungsnase
- 60: Kabeldurchführung in der Aufnahme 30
- 70: erste Gleitfläche
- 71: zweite Gleitfläche
- 80: Verbindungsschraube
- 90: Verbindungsschraube
- 91: Befestigungsdom für PE-Schraube, also Erdung

## Patentansprüche

1. Elektrisches Gerät,
das eine Leiterplatte (12) aufweist, die mit wärmeerzeugenden Bauteilen bestückt ist,
wobei die Leiterplatte (12) in einem Gehäuse des Geräts angeordnet ist,
wobei das Gehäuse ein Gehäuseteil (9) aufweist, insbesondere ein topfförmiges Gehäuseteil (9),
wobei eine mit der Leiterplatte (12) verbundene Kühlplatte (1) von einem Keil gegen die Innenwandung des Gehäuseteils angedrückt ist,
**wobei die Innenwandung sich auf der vom Keil abgewandten Seite der Kühlplatte (1) befindet,**
insbesondere **wobei eine mit der Leiterplatte (12) verbundene Kühlplatte (1) von einem Keil gegen die Innenwandung des Gehäuseteils** derart angedrückt ist, dass an einer Kontaktfläche Wärme zumindest eines wärmeerzeugenden Bauteils, insbesondere eines Leistungshalbleiterschalter aufweisenden Leistungsmodules (5), an das Gehäuseteil (9) abführbar ist,
**wobei der Keil abgestützt ist an einem in den vom Gehäuseteil (9) umgebenen Innenraumbereich des Geräts hineinragenden Abschnitt des Gehäuseteils**
**der Abschnitt eine Führung für den Keil aufweist, wobei die Führung zumindest eine Führungsnut aufweist.**

2. Gerät nach mindestens einem der vorangegangenen Ansprüche,
**dadurch gekennzeichnet, dass**
der Abschnitt ein Befestigungsdom **für PE-Schraube, also Erdung,** ist.

3. Gerät nach mindestens einem der vorangegangenen Ansprüche,
**dadurch gekennzeichnet, dass**
eine Schraube in eine Ausnehmung, insbesondere Gewindebohrung, des Abschnitts derart einschraubbar ist, dass beim Einschrauben die Schraube, insbesondere deren Schraubenkopf, auf den Keil drückt und somit über eine Schrägfläche, insbesondere eine zur Schraubachsrichtung einen Winkel zwischen 0° und 90° aufweisenden Fläche, vom Keil eine Andruckkraft auf die Kühlplatte (1) geleitet wird.

4. Gerät nach mindestens einem der vorangegangenen Ansprüche,
**dadurch gekennzeichnet, dass**
**die Führungsnut** parallel zur Schraubenachsrichtung ausgerichtet ist

5. Gerät nach mindestens einem der vorangegangenen Ansprüche,
**dadurch gekennzeichnet, dass**
der Keil eine Ausnehmung aufweist, insbesondere ein Rundloch oder eine Rundbohrung, durch welches beziehungsweise durch welche die Schraube hindurchragt.

6. Gerät nach mindestens einem der vorangegangenen Ansprüche,
**dadurch gekennzeichnet, dass**
ein Kunststoffkörper die Leiterplatte (12) zumindest teilweise umschließt und mit der bestückten Leiterplatte (12) verbunden ist, insbesondere stoffschlüssig und/oder formschlüssig
und/oder
beidseitig der Leiterplatte (12) ein Kunststoffkörper angeordnet ist und mit der bestückten Leiterplatte (12) verbunden ist, insbesondere stoffschlüssig und/oder formschlüssig.

7. Gerät nach mindestens einem der vorangegangenen Ansprüche,
**dadurch gekennzeichnet, dass**
der Kunststoffkörper aus mindestens zwei miteinander formschlüssig verbundenen Teilkörpern zusammengesetzt ist, insbesondere wobei die formschlüssige Verbindung eine Verrastung (2, 6) ist,
oder dass
der Kunststoffkörper einstückig ausgebildet ist, insbesondere als Umspritzung oder als Kunststoffgussteil hergestellt ist.

8. Gerät nach mindestens einem der vorangegangenen Ansprüche,
**dadurch gekennzeichnet, dass**
die bestückte Leiterplatte (12) an ihrer Oberfläche einen Lack aufweist, insbesondere einen wasserdampfabweisenden Lack und/oder einen wasserabweisenden Lack,
und/oder dass
der Kunststoff als Styropor oder als Schaumstoff, insbesondere als ein Polyurethanschaum, ausgeführt ist,
und/oder dass
der Kunststoff eine bessere Wärmeleitfähigkeit, insbesondere spezifische Wärmeleitfähigkeit, aufweist als Luft,
insbesondere wobei der Kunststoffkörper aus elektrisch isolierendem Werkstoff gefertigt ist.

9. Gerät nach mindestens einem der vorangegangenen Ansprüche,
**dadurch gekennzeichnet, dass**
das Elektrogerät ein Umrichter ist, insbesondere wobei die Signalelektronik und die Leistungselektronik des Umrichters auf der Leiterplatte (12) angeordnet ist.

10. Gerät nach mindestens einem der vorangegangenen Ansprüche,
**dadurch gekennzeichnet, dass**
die Kühlplatte (1) von der Leiterplatte (12) mittels des eines der Wärme erzeugenden Bauelemente beabstandet ist, insbesondere mittels des Leistungsmodules (5),
wobei Leiterplatte (12) und Kühlplatte (1) schraubverbunden sind,
insbesondere wobei die Kühlplatte (1) Aluminium enthält.

11. Gerät nach mindestens einem der vorangegangenen Ansprüche,
**dadurch gekennzeichnet, dass**
die Kühlplatte (1) außerhalb des Kunststoffkörpers angeordnet ist, insbesondere wobei das Leistungsmodul (5) durch eine Ausnehmung des Kunststoffkörpers hindurchragt.

12. Gerät nach mindestens einem der vorangegangenen Ansprüche,
**dadurch gekennzeichnet, dass**
der Kunststoffkörper Ausnehmungen für auf der Leiterplatte (12) bestückte Bauteile, insbesondere für große Bauteile, aufweist.

13. Gerät nach mindestens einem der vorangegangenen Ansprüche,
**dadurch gekennzeichnet, dass**
der Kunststoffkörper, insbesondere der zweite Teilkörper, eine weitere Ausnehmung aufweist, die eine Luftverbindung zwischen einem Wärme erzeugenden, auf der Leiterplatte (12) bestückten Bauelement und einem Oberflächenteilbereich der Kühlplatte (1) ist, insbesondere zur konvektiven Ableitung von Wärme mittels der Luftverbindung an die Kühlplatte (1).

14. Gerät nach mindestens einem der vorangegangenen Ansprüche,
**dadurch gekennzeichnet, dass**
der Kunststoffkörper eine weitere Ausnehmung für ein auf der Leiterplatte (12) bestücktes Bauteil, insbesondere großes Bauteil, aufweist.

15. Gerät nach mindestens einem der vorangegangenen Ansprüche,
**dadurch gekennzeichnet, dass**
eine erste Seite der Leiterplatte (12) oder zumindest ein Teilbereich dieser Seite bedeckt, insbesondere lückenlos bedeckt, ist von dem Kunststoffkörper, insbesondere von dessen erstem Teilkörper, und
die andere Seite der Leiterplatte (12) zumindest teilweise bedeckt ist von dem Kunststoffkörper, insbesondere von dessen zweitem Teilkörper, insbesondere wobei der zweite Teilkörper ringförmig ausgebildet ist.

16. Gerät nach mindestens einem der vorangegangenen Ansprüche,
**dadurch gekennzeichnet, dass**
das Gehäuse des Geräts ein topfförmiges Gehäuseteil (9) aufweist, das von einem Deckelteil (8) verschlossen ist,
insbesondere wobei an der Innenwandung des topfförmigen Gehäuseteils eine Kontaktfläche zur Wärmeeinleitung von der Kühlplatte (1) ans Gehäuse angeordnet ist.

17. Gerät nach mindestens einem der vorangegangenen Ansprüche,
**dadurch gekennzeichnet, dass**
zwischen Deckelteil (8) und Gehäuseteil (9) Kabeldurchführungen angeordnet sind, insbesondere für Versorgungsleitungen, einen Verbraucher speisenden Leitungen und Datenbusleitungen.

18. Verfahren zum Herstellen eines Elektrischen Geräts nach mindestens einem der vorangegangenen Ansprüche,
wobei das Gerät eine zumindest mit einem Leistungsmodul (5) und weiteren Bauteilen bestückte Leiterplatte (12) aufweist, insbesondere wobei die Bauteile und das Leistungsmodul (5) somit auf der Leiterplatte (12) befestigt sind,
**dadurch gekennzeichnet, dass**
(i) in einem Verfahrensschritt die Leiterplatte (12) zumindest teilweise mit einem Kunststoffkörper umschlossen wird, insbesondere
- mit Kunststoff zumindest teilweise umspritzt wird zur Bildung des Kunststoffkörpers
- oder zwischen mindestens zwei Teilkörper des zumindest zweistückig ausgebildeten Kunststoffkörpers eingelegt wird, wobei die Teilkörper nach dem Einlegen miteinander verbunden werden, insbesondere formschlüssig und/oder mittels Verrastung (2, 6),
(ii) in einem nachfolgenden Verfahrensschritt eine Kühlplatte (1) mit dem Leistungsmodul (5) verbunden, insbesondere schraubverbunden, wird,
(iii) in einem weiter nachfolgenden Verfahrensschritt die Leiterplatte (12) samt Kühlplatte (1) und Kunststoffkörper in ein topfförmiges Gehäuseteil (9) eingeschoben wird und die Kühlplatte (1) an einer Kontaktfläche der Innenwandung des Gehäuseteils angedrückt wird, insbesondere wärmeleitend verbunden wird, von einem Keil, welcher beim Schraubverbinden zunehmend die Kühlplatte (1) gegen die Innenwandung des topfförmigen Gehäuseteils drückt.

## Claims

1. Electrical device,
having a printed-circuit board (12) which is fitted with heat-generating components,
wherein the printed-circuit board (12) is disposed in a housing of the device,
wherein the housing has a housing part (9), in particular a cup-shaped housing part (9),
wherein a cooling plate (1) connected to the printed-circuit board (12) is pressed against the inner wall of the housing part by a wedge,
wherein the inner wall is located on the side of the cooling plate (1) facing away from the wedge,
in particular wherein a cooling plate (1) connected to the printed-circuit board (12) is pressed against the inner wall of the housing part by a wedge such that heat from at least one heat-generating component, in particular a power module (5) having power semiconductor switches, is able to be dissipated at a contact surface to the housing par (9),
wherein the wedge is supported against a section of the housing part extending into the interior area of the device surrounded by the housing part (9),
the section has a guide for the wedge, wherein the guide has at least one guide groove.

2. Device according to at least one of the preceding claims, **characterised in that**
the section is a fastening dome for PE screw, thus earthing.

3. Device according to at least one of the preceding claims, **characterised in that**
a screw can be screwed into an opening, in particular threaded bore, of the section such that upon being screwed in, the screw, in particular its screw head, presses on the wedge and thus a pressure force is directed onto the cooling plate (1) via an inclined surface of the wedge, in particular a surface having an angle between 0° and 90° relative to the screw axis direction.

4. Device according to at least one of the preceding claims, **characterised in that**
the guide groove is aligned parallel to the screw axis direction.

5. Device according to at least one of the preceding claims, **characterised in that**
the wedge has an opening, in particular a round hole or a round bore, through which the screw protrudes.

6. Device according to at least one of the preceding claims, **characterised in that**
a plastic body at least partially surrounds the printed-circuit board and is joined, in particular by material locking and/or form locking, to the loaded printed-circuit board (12)
and/or
a plastic body is disposed on both sides of the printed-circuit board (12) and is joined, in particular by material locking and/or form locking, to the loaded printed-circuit board (12).

7. Device according to at least one of the preceding claims, **characterised in that**
the plastic body is assembled from at least two sub-bodies joined to each other by form locking, in particular wherein the form-locking joining is a latching (2, 6),
or **in that**
the plastic body is formed in one piece, in particular as an overmould or as a plastic casting.

8. Device according to at least one of the preceding claims, **characterised in that**
the loaded printed-circuit board (12) has a lacquer, in particular a water-vapour-repellent lacquer and/or a water-repellent lacquer, on its surface,
and/or **in that**
the plastic is made of Styropor or foamed plastic, in particular a polyurethane foam,
and/or **in that**
the plastic has better thermal conductivity, in particular specific thermal conductivity, than air,
in particular wherein the plastic body is made of electrically insulating material.

9. Device according to at least one of the preceding claims, **characterised in that**
the electrical device is a converter, in particular wherein the signal electronics and the power electronics of the converter are disposed on the printed-circuit board (12).

10. Device according to at least one of the preceding claims, **characterised in that**
the cooling plate (1) is set apart from the printed-circuit board (12) by means of the heat-generating components, in particular by means of the power module (5),
wherein the printed-circuit board (12) and the cooling plate (1) are screw-connected,
in particular wherein the cooling plate (1) contains aluminium.

11. Device according to at least one of the preceding claims, **characterised in that**
the cooling plate (1) is disposed outside the plastic body, in particular wherein the power module (5) protrudes through an opening in the plastic body.

12. Device according to at least one of the preceding claims, **characterised in that**
the plastic body has openings for components, in particular for large components, fitted on the printed-circuit board (12).

13. Device according to at least one of the preceding claims, **characterised in that**
the plastic body, in particular the second sub-body, has a further opening which is an air connection between a heat-generating component fitted on the printed-circuit board (12) and a surface partial area of the cooling plate (1), in particular for connective dissipation of heat by means of the air connection to the cooling plate (1).

14. Device according to at least one of the preceding claims, **characterised in that**
the plastic body has a further opening for a component, in particular large component, fitted on the printed-circuit board (12).

15. Device according to at least one of the preceding claims, **characterised in that**
the first side of the printed-circuit board (12) or at least a partial area of this side is covered, in particular completely covered, by the plastic body, in particular by its first sub-body, and
the other side of the printed-circuit board (1) is covered at least partially by the plastic body, in particular by its second sub-body, in particular wherein the second sub-body is ring-shaped.

16. Device according to at least one of the preceding claims, **characterised in that**
the housing of the device has a cup-shaped housing part (9) which is closed by a cover part (8),
in particular wherein a contact surface for transfer of heat from the cooling plate (1) to the housing is disposed on the inner wall of the cup-shaped housing part.

17. Device according to at least one of the preceding claims, **characterised in that**
cable lead-throughs, in particular for supply lines, lines feeding a load and data-bus lines, are disposed between the cover part (8) and the housing part (9).

18. Method for manufacturing an electrical device according to at least one of the preceding claims,
wherein the device has a printed-circuit board (12) fitted at least with a power module (6) and further components, in particular wherein the components and the power module (5) are thus secured on the printed-circuit board (12),
**characterised in that**
(i) in one method step the printed-circuit board (12) is enclosed at least partially by a plastic body, in particular
- is overmoulded at least partially with plastic to form the plastic body,
- or is inserted between at least two sub-bodies of the at least two-piece plastic body, wherein the sub-bodies are joined to each other after the insertion, in particular by form locking and/or latching (2, 6),
(ii) in a subsequent method step a cooling plate (1) is connected, in particular screw-connected, to the power module (5),
(iii) in a further subsequent method the printed-circuit board (12), together with the cooling plate (1) and the plastic body, is inserted into a cup-shaped housing part (9) and the cooling plate (1) is pressed against a contact surface on the inner wall of the housing part, in particular joined in heat-conducting manner, by a wedge which presses the cooling plate (1) increasingly against the inner wall of the cup-shaped housing part upon the screw connection.

## Revendications

1. Appareil électrique
muni d'une plaquette imprimée (12) garnie de composants générateurs de chaleur,
ladite plaquette imprimée (12) étant logée dans un boîtier de l'appareil,
ledit boîtier comportant une partie (9), notamment une partie (9) configurée en un pot, une platine de refroidissement (1) reliée à ladite plaquette imprimée (12) étant pressée, par une cale, contre la paroi intérieure de ladite partie du boîtier,
laquelle paroi intérieure se trouve du côté de ladite platine de refroidissement (1) qui est tourné à l'opposé de ladite cale,
sachant notamment qu'une platine de refroidissement (1) reliée à la plaquette imprimée (12) est pressée par une cale, contre la paroi intérieure de ladite partie du boîtier, de façon telle que de la chaleur d'au moins un composant générateur de chaleur, en particulier d'un module de puissance (5) pourvu de commutateurs à semi-conducteurs de puissance, puisse être évacuée vers ladite partie (9) du boîtier au niveau d'une surface de contact, ladite cale étant en appui contre un tronçon de ladite partie du boîtier pénétrant dans la région de l'espace interne de l'appareil qui est entourée par ladite partie (9) du boîtier, ledit tronçon présentant un guide dévolu à ladite cale, lequel guide est doté d'au moins une rainure de guidage.

2. Appareil selon la revendication 1,
**caractérisé par le fait que**
le tronçon se présente comme une bossette de fixation destinée à une vis PE, c'est-à-dire à une mise à la terre.

3. Appareil selon au moins l'une des revendications précédentes, **caractérisé par le fait**
**qu'**une vis peut être vissée dans un évidement, notamment dans un perçage taraudé du tronçon, de telle sorte que ladite vis, en particulier la tête de cette dernière, exerce une pression sur la cale lors du vissage, et que ladite cale applique ainsi une force de pression à la platine de refroidissement (1) par l'intermédiaire d'une surface inclinée, notamment d'une surface décrivant un angle compris entre 0° et 90° par rapport à la direction axiale de ladite vis.

4. Appareil selon au moins l'une des revendications précédentes, **caractérisé par le fait que**
la rainure de guidage est orientée parallèlement à la direction axiale de la vis.

5. Appareil selon au moins l'une des revendications précédentes, **caractérisé par le fait que**
la cale présente un évidement, en particulier un trou circulaire ou un perçage circulaire respectivement traversé par la vis.

6. Appareil selon au moins l'une des revendications précédentes, **caractérisé par le fait**
**qu'**un corps en matière plastique entoure au moins partiellement la plaquette imprimée (12) et est relié à ladite plaquette imprimée garnie (12), notamment par solidarisation matérielle et/ou par complémentarité de formes,
et/ou
**qu'**un corps en matière plastique est disposé des deux côtés de la plaquette imprimée (12) et est relié à ladite plaquette imprimée garnie (12), notamment par solidarisation matérielle et/ou par complémentarité de formes.

7. Appareil selon au moins l'une des revendications précédentes, **caractérisé par le fait que**
le corps en matière plastique est composé d'au moins deux corps partiels reliés l'un à l'autre par complémentarité de formes, la liaison par complémentarité de formes se présentant notamment comme un encliquetage (2, 6),
ou que
ledit corps en matière plastique est de réalisation monobloc et est fabriqué, en particulier, comme un enrobage injecté ou comme une pièce moulée en matière plastique.

8. Appareil selon au moins l'une des revendications précédentes, **caractérisé par le fait que**
la plaquette imprimée garnie (12) présente une laque à sa surface, en particulier une laque repoussant la vapeur d'eau et/ou une laque hydrofuge,
et/ou que
la matière plastique se présente comme du polystyrène ou comme une mousse, en particulier comme une mousse de polyuréthane,
et/ou que
ladite matière plastique possède une conductivité thermique, en particulier une conductivité thermique spécifique meilleure que celle de l'air,
le corps en matière plastique étant notamment fabriqué en un matériau électriquement isolant.

9. Appareil selon au moins l'une des revendications précédentes, **caractérisé par le fait que**
ledit appareil électrique est un inverseur, sachant notamment que l'électronique de signalisation et l'électronique de puissance dudit inverseur sont situées sur la plaquette imprimée (12).

10. Appareil selon au moins l'une des revendications précédentes, **caractérisé par le fait que**
la platine de refroidissement (1) est espacée de la plaquette imprimée (12) au moyen de l'un des composants générateurs de chaleur, notamment au moyen du module de puissance (5),
ladite plaquette imprimée (12) et ladite platine de refroidissement (1) étant solidarisées par vissage,
sachant notamment que ladite platine de refroidissement (1) renferme de l'aluminium.

11. Appareil selon au moins l'une des revendications précédentes, **caractérisé par le fait que**
la platine de refroidissement (1) est placée à l'extérieur du corps en matière plastique, sachant notamment que le module de puissance (5) traverse un évidement dudit corps en matière plastique.

12. Appareil selon au moins l'une des revendications précédentes, **caractérisé par le fait que**
le corps en matière plastique comporte des évidements destinés à des composants mis en place sur la plaquette imprimée (12), notamment à des composants de grand dimensionnement.

13. Appareil selon au moins l'une des revendications précédentes, **caractérisé par le fait que**
le corps en matière plastique, en particulier le second corps partiel, est muni d'un évidement supplémentaire instaurant une liaison par circulation d'air entre un composant générateur de chaleur, mis en place sur la plaquette imprimée (12), et une région partielle de la surface de la platine de refroidissement (1), notamment en vue d'évacuer de la chaleur par convection vers ladite platine de refroidissement (1), au moyen de ladite liaison par circulation d'air.

14. Appareil selon au moins l'une des revendications précédentes, **caractérisé par le fait que**
le corps en matière plastique comporte un évidement supplémentaire destiné à un composant mis en place sur la plaquette imprimée (12), notamment à un composant de grand dimensionnement.

15. Appareil selon au moins l'une des revendications précédentes, **caractérisé par le fait**
**qu'**un premier côté de la plaquette imprimée (12), ou au moins une région partielle de ce côté, est recouvert(e), en particulier recouvert(e) sans discontinuité par le corps en matière plastique et notamment par le premier corps partiel de celui-ci, et
l'autre côté de ladite plaquette imprimée (12) est au moins partiellement recouvert par ledit corps en matière plastique, en particulier par le second corps partiel de ce dernier, sachant notamment que ledit second corps partiel est de réalisation annulaire.

16. Appareil selon au moins l'une des revendications précédentes, **caractérisé par le fait que**
le boîtier dudit appareil comporte une partie (9) configurée en un pot et obturée par une partie (8) formant couvercle,
sachant notamment qu'une surface de contact est située sur la paroi intérieure de ladite partie du boîtier configurée en un pot, en vue d'une introduction de chaleur gagnant ledit boîtier à partir de la platine de refroidissement (1).

17. Appareil selon au moins l'une des revendications précédentes, **caractérisé par le fait que**
des traversées de câbles sont interposées entre la partie (8) formant couvercle et la partie (9) du boîtier, en particulier pour des conducteurs d'alimentation, des conducteurs alimentant un appareil consommateur, et des lignes de bus de données.

18. Procédé de fabrication d'un appareil électrique conforme à au moins l'une des revendications précédentes,
ledit appareil présentant une plaquette imprimée (12) garnie d'au moins un module de puissance (5) et de composants supplémentaires, sachant notamment que lesdits composants et ledit module de puissance (5) sont ainsi fixés sur ladite plaquette imprimée (12),
**caractérisé par le fait que**
(i) au cours d'une étape opératoire, la plaquette imprimée (12) est au moins partiellement entourée d'un corps en matière plastique, en étant notamment
- au moins partiellement enrobée de matière plastique, par injection, en vue de former ledit corps en matière plastique,
- ou intégrée entre au moins deux corps partiels dudit corps en matière plastique réalisé en au moins deux parties, lesdits corps partiels étant reliés l'un à l'autre à l'issue de l'intégration, notamment par complémentarité de formes et/ou par encliquetage (2, 6),
(ii) au cours d'une étape opératoire suivante, une platine de refroidissement (1) est reliée au module de puissance (5), notamment solidarisée par vissage,
(iii) au cours d'une autre étape opératoire successive, ladite plaquette imprimée (12) est insérée, conjointement à ladite platine de refroidissement (1) et audit corps en matière plastique, dans une partie (9) de boîtier configurée en un pot, et ladite platine de refroidissement (1) est pressée contre une surface de contact de la paroi intérieure de ladite partie de boîtier en étant notamment reliée, avec conduction thermique, par une cale exerçant une pression croissante sur ladite platine de refroidissement (1), lors de la solidarisation par vissage, contre la paroi intérieure de ladite partie de boîtier configurée en un pot.
